# EUROPEAN PATENT SPECIFICATION

(11) **EP 4 345 891 B1**
(45) Date of publication and mention of the grant of the patent: **03.09.2025**
(21) Application number: 23198385.9
(22) Date of filing: 19.09.2023
(51) Int. Cl.: H01L 23/495, H01L 23/31

(54) **POWER LEADFRAME PACKAGE WITH REDUCED SOLDER VOIDS**
LEISTUNGSRAHMENGEHÄUSE MIT REDUZIERTEN LÖTHOHLRÄUMEN
BOÎTIER DE GRILLE DE CONNEXION DE PUISSANCE À VIDES DE SOUDURE RÉDUITS

(30) Priority: 29.09.2022 US 202263411306 P; 11.08.2023 US 202318233092
(43) Date of publication of application: 03.04.2024
(73) Proprietor: STMicroelectronics, Inc., 4027 Calamba City, Laguna (PH)
(72) Inventor: TALLEDO, Jefferson Sismundo, 4027 Calamba, Laguna (PH)
(74) Representative: Cabinet Beaumont

(56) References cited:
- US-A1- 2008 087 992
- US-A1- 2012 133 037
- US-B2- 6 723 582

## Description

### TECHNICAL FIELD

This disclosure is related to the field of electronic devices and, more particularly, to designs for clip interconnects that facilitate assembly without the formation of solder voids between such clip interconnects and integrated circuit (IC) die during solder reflow.

### BACKGROUND

In many conventional applications, an integrated circuit (IC) die of an electronic device is interconnected with other components of the electronic device using wire bonds. However, in certain high-current applications, the use of wire bonds may be impractical due to the number of wire bonds needed to carry the expected current load, which in turns increases the complexity involved in device assembly. Therefore, in such high-current applications, a clip interconnect may be used to provide for interconnection between the integrated circuit die and other components due to the high current carrying capacity of clip interconnects.

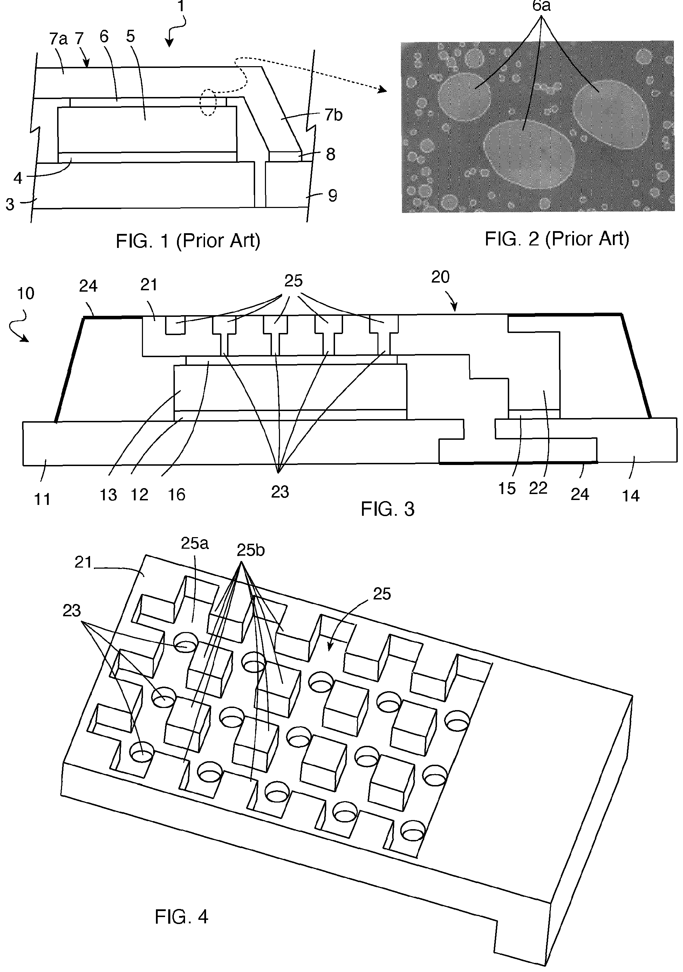

A cross section of a known electronic device 1 utilizing a clip interconnect is shown in FIG. 1. The bottom face of an IC die 5 is bonded to a top surface of a die pad 3 of a leadframe through a die attach layer 4 (e.g., solder layer), and the top face of the IC die 5 is bonded to a bottom surface of a first portion 7a of a clip 7 through a solder layer 6. The clip 7 has a second portion 7b extending from the first portion 7a at an angle thereto, with a bottom surface of the second portion 7b of the clip 7 being bonded to a top surface of a lead or leads 9 of the leadframe through a solder layer 8.

During device assembly, a solder material is used to attach the bottom face of the IC die 5 to the top surface of the die pad 3, the top face of the IC die 5 to the bottom surface of the first portion 7a of the clip 7, and the top surface of the leads 9 to bottom surface of the section portion 7b of the clip 7, after which point the electronic device 1 assembly is subjected to a controlled heating to form the solder layers 4, 6, and 8. However, the solder material has volatile components (e.g., flux) therein that release bubbles of gas during solidification. If these bubbles of gas are trapped between the surfaces being bonded via the solder reflow process, voids within the solder layers, particularly solder layer 6, are thereby formed. Shown in FIG. 2 is a cross sectional view of the solder layer 6, including voids 6a formed therein. Such solder voids increase the thermal resistance between the layers, reducing heat dissipation capacity, creating local hot spots. Such solder voids also decrease the electrical conductivity between the layers, potentially degrading device performance.

In an attempt to ensure that such bubbles of gas are not trapped between the surfaces being bonded, the reflow process may be carefully optimized. However, this optimization is a trial and error process and grows in difficulty to perform as the IC die 5 and clip 7 increase in size.

Prior art is disclosed in documents US2012/133037 A1, US6723582 B2 and US2008/087992 A1.

As such, further development into assembly techniques and clip designs is necessary

### SUMMARY

Disclosed herein is an electronic device, including a first support substrate, with a second support substrate spaced apart from the first support substrate. An integrated circuit (IC) die has opposed first and second faces, the second face bonded to a first surface of the first support substrate. A conductive clip is formed by first and second portions each having opposed first and second surfaces, the first portion of the conductive clip being elongate and extending across the IC die, the first portion of the conductive clip having its second surface bonded to the first face of the IC die by a solder layer, the second portion of the conductive clip extending from the first portion away from the IC die toward the second support substrate such that its second surface is bonded to the first surface of the second support substrate.

The first surface of the conductive clip has a pattern formed therein, the pattern including a depressed floor with fins extending upwardly therefrom. Through-holes extend through the first surface of the conductive clip from the depressed floor of the pattern to the second surface of the conductive clip. An encapsulating layer covers portions of the first support substrate, second support substrate, IC die, and conductive clip while leaving the first surface of the first portion of the conductive clip exposed to permit heat to radiate away therefrom.

The through-holes may be straight-cut, being equal in size and shape at the depressed floor of the pattern and at the second surface of the conductive clip.

The through-holes may expand in size from the depressed floor of the pattern through to the second surface of the conductive clip such that the size of the through-holes at the depressed floor is less than the size of the through-holes at the second surface of the conductive clip.

The through-holes may contract in size from the depressed floor of the pattern through to the second surface of the conductive clip such that the size of the through-holes at the depressed floor is larger than the size of the through-holes at the second surface of the conductive clip.

The through-holes may have cross sections that are circular in shape, or may have cross sections that are pill shaped.

The fins may extend upwardly from the depressed floor to a level of a highest point of the first surface of the first portion of the conductive clip.

The second surface of the first portion of the conductive clip may be planar.

The first support substrate may be a die pad of a leadframe, and the second support substrate may be at least one lead of a leadframe.

### BRIEF DESCRIPTION OF THE DRAWINGS

FIG. 1 is a diagrammatical cross sectional view of a prior art electronic device utilizing a conductive clip interconnect.
FIG. 2 is a pictorial representation of solder voids formed in the solder layer in FIG. 1 bonding the bottom surface of the conductive clip to the top face of the integrated circuit.
FIG. 3 a diagrammatical cross sectional view of an electronic device disclosed herein utilizing a conductive clip interconnect.
FIG. 4 is a perspective view of a first embodiment of the conductive clip of FIG. 3.
FIG. 5 is a perspective view of a second embodiment of the conductive clip of FIG. 3.
FIG. 6 is a perspective view of a third embodiment of the conductive clip of FIG. 3.
FIG. 7 is a perspective view of a fourth embodiment of the conductive clip of FIG. 3.

### DETAILED DESCRIPTION

The following disclosure enables a person skilled in the art to make and use the subject matter disclosed herein. The general principles described herein may be applied to embodiments and applications other than those detailed above without departing from the spirit and scope of this disclosure. This disclosure is not intended to be limited to the embodiments shown, but is to be accorded the widest scope consistent with the principles and features disclosed or suggested herein.

Now described with reference to FIGS. 3-4 is an electronic device 10 including a die pad 11 (e.g., part of a leadframe) and leads 14 (e.g., part of the leadframe) spaced apart from one another, with a conductive clip 20 (formed of e.g., copper) forming an interconnect therebetween. As will be explained below, the conductive clip 20 is specifically designed to alleviate concerns of the formation of solder voids during solder reflow.

In greater detail, the top surface of a die pad 11 is bonded to the bottom face of the IC 13 through a die attach layer 12 (e.g., a solder layer such as soft solder/Ag sintering). The conductive clip 20 includes a first portion 21 having a planar bottom surface bonded to the top face of the IC 13 through a die attach layer (e.g., a solder layer 16 such as soft solder/Ag sintering), and a second portion 22 extending from the first portion 21 laterally away from the IC 13 such that a planar bottom surface of the second portion 22 is bonded to the top surface of the leads 14 through a die attach layer 15 (e.g., a solder layer such as soft solder/Ag sintering). Observe that the second portion 22 of the conductive clip 20 has a stair-stepped shape defining a step down in height from the top face of the IC 13 to the top surface of the leads 14. Observe also that the first portion 21 of the conductive clip 21 is elongate and extends across the IC 13.

An encapsulation layer 24 extends from the top surfaces of the die pad 11 and leads 14 to be flush with a top surface of the first portion 21 of the conductive clip 20, environmentally sealing the sides and bottom surface of the first portion 21, environmentally sealing the IC 13, and environmentally sealing the covered portion of the top surface of the die pad 11, while leaving the top surface of the first portion 21 exposed. The encapsulation layer 24 also environmentally seals the second portion 22 and the covered portion of the top surface of the leads 14. Notice that the encapsulation layer 24 also environmentally seals the gap between the die pad 11 and the leads 14.

As has been explained above, during the solder reflow process, it is desired to prevent solder voids from forming in the solder 16 to the extent possible, thereby providing for more effective heat transfer from the IC 13 to the conductive clip 20. To facilitate this, the first portion 21 of the conductive clip 20 has through-holes 23 defined therein. These through-holes 23 are shaped and positioned so as to permit the gasses released from volatile components during solder reflow to escape the solder layer 16 through the through-holes 23, thereby eliminating the formation of solder voids by those gases and enhancing the cooling ability of the electronic device 10 as well as potentially enhancing the improving device performance by increasing electrical conductivity between the IC 13, conductive clip 20, and leads 14.

The top surface of the first portion 21 of the conductive clip 20 being left exposed by the encapsulation layer 24 helps provide for the ability of heat in the clip 20 to radiate away from the clip 20 and dissipate. To enhance this effect, the top surface of the first portion 21 of the conductive clip 20 has its exposed surface area increased by a pattern 25 being defined thereon. The pattern 25 includes a depressed floor 25a defined by a plurality of interconnected a recesses or channels formed extending into the top surface of the first portion 21 of the conductive clip 20, with projections or fins 25b (delimited by the recesses or channels) extending upwardly from the depressed floor 25a. The fins 25b may extend up to a level aligned with a highest point of other portions of the top surface of the first portion 21 of the conductive clip 20, may extend to a level above the above the other highest point of other portions of the top surface of the first portion 21 of the conductive clip 20, or may extend up to a level below a highest point of other portions of the top surface of the first portion 21 of the conductive clip 20. By increasing the surface area of the top surface of the first portion 21 of the conductive clip 20, heat can more easily radiate outwardly and away.

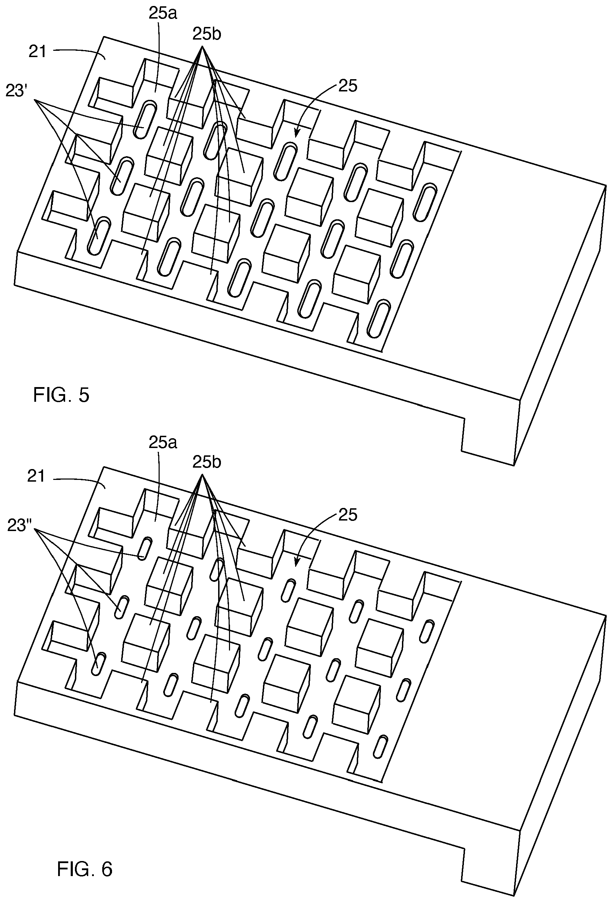

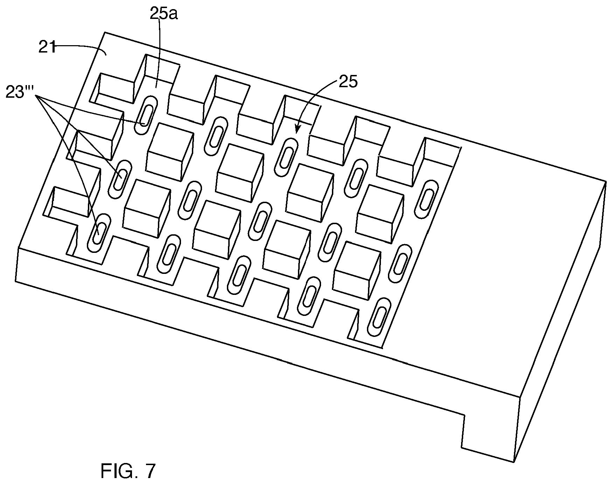

In the illustrative example of FIG. 4, the through-holes 23 are circularly shaped and are uniform in diameter from the top surface of the first portion 21 of the conductive clip 20 through to the bottom surface of the first portion 21 of the conductive clip 20 (e.g., formed by a straight cut). However, the through-holes 23 may take other suitable shapes. For example, the through-holes 23' may be elliptical in shape or may be pill shaped as shown in FIG. 5. The through-holes 23" may tapered in cut, wider at the top surface of the first portion 21 of the conductive clip 20 than at the bottom surface of the first portion 21 of the conductive clip 20, as shown in FIG. 6. The through-holes 23‴ may instead be tapered in the cut in the opposite fashion, narrower at the top surface of the first portion 21 of the conductive clip 20 than at the bottom surface of the first portion 21 of the conductive clip 20, as shown in FIG. 7.

The spacing and pattern of the through-holes 23 may be adjusted depending upon the surface area of the top face of the IC 13 and the surface area of the top surface of the first portion 21 of the conductive clip 20, depending upon the expected operating conditions of the IC 13, and/or depending upon the specific composition of the solder layer 16.

A method for making the electronic device 10 is now described. The method includes providing a substrate or leadframe carrying the die pad 11, and bonding the bottom face of the IC 13 to the top surface of the die pad 11 through the solder layer 12. The bottom surface of the first portion 21 of the conductive clip 20 is then bonded to the top face of the IC 13 through the solder layer 16, and at this step, the bottom surface of the second portion 21 of the conductive clip 21 is bonded to the top surface of the leads 14 through the solder layer 15. Thereafter, solder reflow is performed and the electronic device 10 is permitted to cool before the encapsulation layer 24 is deposited.

While the disclosure has been described with respect to a limited number of embodiments, those skilled in the art, having benefit of this disclosure, will appreciate that other embodiments can be envisioned that do not depart from the scope of the disclosure as disclosed herein. Accordingly, the scope of the disclosure shall be limited only by the attached claims.

## Claims

1. An electronic device, comprising:
a first support substrate;
a second support substrate spaced apart from the first support substrate;
an integrated circuit (IC) die having opposed first and second faces, the second face bonded to a first surface of the first support substrate;
a conductive clip formed by first and second portions each having opposed first and second surfaces, the first portion of the conductive clip being elongate and extending across the IC die, the first portion of the conductive clip having its second surface bonded to the first face of the IC die by a solder layer, the second portion of the conductive clip extending from the first portion away from the IC die toward the second support substrate such that its second surface is bonded to the first surface of the second support substrate;
wherein the first surface of the conductive clip has a pattern formed therein, the pattern including a depressed floor with fins extending upwardly therefrom;
wherein through-holes extend through the first surface of the conductive clip from the depressed floor of the pattern to the second surface of the conductive clip; and
an encapsulating layer covering portions of the first support substrate, second support substrate, IC die, and conductive clip while leaving the first surface of the first portion of the conductive clip exposed to permit heat to radiate away therefrom.

2. The electronic device of claim 1, wherein the fins extend upwardly from the depressed floor to a level of a highest point of the first surface of the first portion of the conductive clip.

3. The electronic device of claim 1 or 2, wherein the second surface of the first portion of the conductive clip is planar.

4. A method of making an electronic device, comprising:
forming a conductive clip from first and second portions each having opposed first and second surfaces so that the first portion of the conductive clip is elongate and so that the second portion of the conductive clip extend outwardly away from the first portion of the conductive clip in an out-of-plane direction;
forming a pattern in the first surface of the first portion of the conductive clip so that the pattern includes a depressed floor with fins extending upwardly therefrom;
forming through-holes in the depressed floor of the first portion of the conductive clip;
coupling a second face of an integrated circuit (IC) to a first surface of a first support substrate;
bonding the second surface of the first portion of the conductive clip to a first face of the IC through a solder layer formed therebetween;
coupling the second surface of the second portion of the conductive clip to a first surface of a second support substrate that is spaced apart from the IC;
heating the electronic device so as to reflow the solder layer, with gases released from the solder layer during reflow escaping the electronic device through the through-holes; permitting the electronic device to cool; and
forming an encapsulation layer over the electronic device such that the first surface of the conductive clip is left exposed.

5. The method of claim 4, further comprising, prior to coupling a second face of the integrated circuit (IC) to the first surface of a first support substrate, coupling the second surface of the first support substrate to a first surface of base substrate; and further comprising, after forming the encapsulation layer, removing the base substrate from the first support substrate.

6. The device of any of claims 1 to 3, or the method of claim 4 or 5, wherein the through-holes are straight-cut, being equal in size and shape at the depressed floor of the pattern and at the second surface of the conductive clip.

7. The device of any of claims 1 to 3 or 6, or the method of any of claims 4 to 6, wherein the through-holes expand in size from the depressed floor of the pattern through to the second surface of the conductive clip such that the size of the through-holes at the depressed floor is less than the size of the through-holes at the second surface of the conductive clip.

8. The device of any of claims 1 to 3 or 6, or the method of any of claims 4 to 6, wherein the through-holes contract in size from the depressed floor of the pattern through to the second surface of the conductive clip such that the size of the through-holes at the depressed floor is larger than the size of the through-holes at the second surface of the conductive clip.

9. The device of any of claims 1 to 3, 6 to 8, or the method of any of claims 4 to 8, wherein the through-holes have cross sections that are circular in shape.

10. The device of any of claims 1 to 3, 6 to 9, or the method of any of claims 4 to 9, wherein the through-holes have cross sections that are pill shaped.

11. The device of any of claims 1 to 3, 6 to 9, or the method of any of claims 4 to 10, wherein the first support substrate is a die pad of a leadframe.

12. The device of any of claims 1 to 3, 6 to 9, or the method of any of claims 4 to 11, wherein the second support substrate is at least one lead of a leadframe.

## Patentansprüche

1. Eine elektronische Vorrichtung, die Folgendes aufweist:
ein erstes Trägersubstrat;
ein zweites Trägersubstrat, das vom ersten Trägersubstrat beabstandet ist;
einen integrierten Schaltkreis (IC)-Chip mit einer ersten und einer zweiten gegenüberliegenden Fläche, wobei die zweite Fläche an eine erste Oberfläche des ersten Trägersubstrats gebondet ist;
eine leitfähige Klammer, die aus einem ersten und einem zweiten Abschnitt gebildet ist, die jeweils eine erste und eine zweite gegenüberliegende Oberfläche haben, wobei der erste Abschnitt der leitfähigen Klammer länglich ist und sich über den IC-Chip erstreckt, wobei die zweite Oberfläche des ersten Abschnitts der leitfähigen Klammer durch eine Lötmittelschicht an die erste Fläche des IC-Chips gebondet ist, wobei sich der zweite Abschnitt der leitfähigen Klammer vom ersten Abschnitt weg vom IC-Chip in Richtung des zweiten Trägersubstrats erstreckt, so dass seine zweite Oberfläche an die erste Oberfläche des zweiten Trägersubstrats gebondet ist;
wobei die erste Oberfläche der leitfähigen Klammer ein darin ausgebildetes Muster hat, wobei das Muster einen vertieften Boden mit Finnen aufweist, die sich von diesem nach oben erstrecken;
wobei Durchgangslöcher sich durch die erste Oberfläche der leitfähigen Klammer vom vertieften Boden des Musters zur zweiten Oberfläche der leitfähigen Klammer erstrecken; und
eine Verkapselungsschicht, die Abschnitte des ersten Trägersubstrats, des zweiten Trägersubstrats, des IC-Chips und der leitfähigen Klammer bedeckt, während sie die erste Oberfläche des ersten Abschnitts der leitfähigen Klammer freilässt, um Wärme von dieser abstrahlen zu lassen.

2. Die elektronische Vorrichtung nach Anspruch 1, wobei sich die Finnen aufwärts von dem vertieften Boden bis zu einer Ebene eines höchsten Punktes der ersten Oberfläche des ersten Abschnitts der leitfähigen Klammer erstrecken.

3. Die elektronische Vorrichtung nach Anspruch 1 oder 2, wobei die zweite Oberfläche des ersten Abschnitts der leitfähigen Klammer planar ist.

4. Ein Verfahren zur Herstellung einer elektronischen Vorrichtung, das Folgendes aufweist:
Ausbilden einer leitfähigen Klammer aus einem ersten und einem zweiten Abschnitt, die jeweils eine erste und eine zweite gegenüberliegende Oberfläche haben, so dass der erste Abschnitt der leitfähigen Klammer länglich ist und sich der zweite Abschnitt der leitfähigen Klammer vom ersten Abschnitt der leitfähigen Klammer in einer Richtung außerhalb der Ebene nach außen erstreckt;
Ausbilden eines Musters in der ersten Fläche des ersten Abschnitts des leitfähigen Clips, so dass das Muster einen vertieften Boden mit Finnen aufweist, die sich davon nach oben erstrecken;
Ausbilden von Durchgangslöchern in dem vertieften Boden des ersten Abschnitts der leitfähigen Klammer;
Koppeln einer zweiten Fläche einer integrierten Schaltung (IC) mit einer ersten Oberfläche eines ersten Trägersubstrats;
Bonden der zweiten Oberfläche des ersten Abschnitts der leitfähigen Klammer mit einer ersten Oberfläche des IC über eine dazwischen ausgebildete Lötmittelschicht;
Koppeln der zweiten Oberfläche des zweiten Abschnitts der leitfähigen Klammer mit einer ersten Oberfläche eines zweiten Trägersubstrats, das vom IC beabstandet ist;
Erhitzen der elektronischen Vorrichtung, um die Lötschicht wieder aufschmelzen zu lassen, wobei Gase, die
während des Aufschmelzens aus der
Lötschicht freigesetzt werden, durch die Durchgangslöcher aus der elektronischen Vorrichtung entweichen;
Abkühlenlassen der elektronischen Vorrichtung; und
Ausbilden einer Verkapselungsschicht über der elektronischen Vorrichtung, so dass die erste Oberfläche der leitfähigen Klammer frei bleibt.

5. Das Verfahren nach Anspruch 4, ferner aufweisend, vor dem Koppeln einer zweiten Fläche der integrierten Schaltung (IC) mit der ersten Oberfläche eines ersten Trägersubstrats, Koppeln der zweiten Oberfläche des ersten Trägersubstrats mit einer ersten Oberfläche eines Basissubstrats; und ferner aufweisend, nach Ausbilden der Verkapselungsschicht, Entfernen des Basissubstrats von dem ersten Trägersubstrat.

6. Die Vorrichtung nach einem der Ansprüche 1 bis 3 oder das Verfahren nach Anspruch 4 oder 5, wobei die Durchgangslöcher gerade geschnitten sind und hinsichtlich Größe und Form am vertieften Boden des Musters und an der zweiten Oberfläche der leitfähigen Klammer gleich sind.

7. Die Vorrichtung nach einem der Ansprüche 1 bis 3 oder 6 oder das Verfahren nach einem der Ansprüche 4 bis 6, wobei sich die Durchgangslöcher vom vertieften Boden des Musters bis zur zweiten Oberfläche der leitfähigen Klammer in ihrer Größe erweitern, so dass die Größe der Durchgangslöcher am vertieften Boden kleiner ist als die Größe der Durchgangslöcher an der zweiten Oberfläche der leitfähigen Klammer.

8. Die Vorrichtung nach einem der Ansprüche 1 bis 3 oder 6 oder das Verfahren nach einem der Ansprüche 4 bis 6, wobei sich die Durchgangslöcher vom vertieften Boden des Musters bis zur zweiten Oberfläche der leitfähigen Klammer in ihrer Größe verkleinern, so dass die Größe der Durchgangslöcher am vertieften Boden größer ist als die Größe der Durchgangslöcher an der zweiten Oberfläche der leitfähigen Klammer.

9. Die Vorrichtung nach einem der Ansprüche 1 bis 3, 6 bis 8 oder das Verfahren nach einem der Ansprüche 4 bis 8, wobei die Durchgangslöcher Querschnitte aufweisen, die kreisförmig sind.

10. Die Vorrichtung nach einem der Ansprüche 1 bis 3, 6 bis 9 oder das Verfahren nach einem der Ansprüche 4 bis 9, wobei die Durchgangslöcher Querschnitte aufweisen, die pillenförmig sind.

11. Die Vorrichtung nach einem der Ansprüche 1 bis 3, 6 bis 9 oder das Verfahren nach einem der Ansprüche 4 bis 10, wobei das erste Trägersubstrat ein Chip-Pad eines Leiterrahmens ist.

12. Die Vorrichtung nach einem der Ansprüche 1 bis 3, 6 bis 9 oder das Verfahren nach einem der Ansprüche 4 bis 11, wobei das zweite Trägersubstrat wenigstens eine Leitung eines Leiterrahmens ist.

## Revendications

1. Dispositif électronique, comprenant :
un premier substrat de support ;
un deuxième substrat de support espacé du premier substrat de support ;
une puce de circuit intégré (IC) ayant des première et deuxième faces opposées, la deuxième face étant collée à une première surface du premier substrat de support ;
une pince conductrice formée par des première et deuxième parties ayant chacune des première et deuxième surfaces opposées, la première partie de la pince conductrice étant allongée et s'étendant à travers la puce IC, la première partie de la pince conductrice ayant sa deuxième surface collée à la première face de la puce IC par une couche de soudure, la deuxième partie de la pince conductrice s'étendant depuis la première partie à l'écart de la puce IC vers le deuxième substrat de support de sorte que sa deuxième surface soit collée à la première surface du deuxième substrat de support ;
dans lequel un motif est formé dans la première surface de la pince conductrice, le motif comportant un plancher en dépression à partir duquel des ailettes s'étendent vers le haut ;
dans lequel des orifices traversants s'étendent à travers la première surface de la pince conductrice depuis le fond en dépression du motif jusqu'à la deuxième surface de la pince conductrice ; et
une couche d'encapsulation recouvrant des parties du premier substrat de support, du deuxième substrat de support, de la puce IC et de la pince conductrice tout en laissant la première surface de la première partie de la pince conductrice exposée pour permettre à la chaleur de rayonner loin de celle-ci.

2. Dispositif électronique selon la revendication 1, dans lequel les ailettes s'étendent vers le haut depuis le plancher en dépression jusqu'à un niveau d'un point le plus élevé de la première surface de la première partie de la pince conductrice.

3. Dispositif électronique selon la revendication 1 ou 2, dans lequel la deuxième surface de la première partie de la pince conductrice est plane.

4. Procédé de fabrication d'un dispositif électronique, comprenant :
la formation d'une pince conductrice à partir de première et deuxième parties ayant chacune des première et deuxième surfaces opposées de sorte que la première partie de la pince conductrice soit allongée et de sorte que la deuxième partie de la pince conductrice s'étende vers l'extérieur à l'écart de la première partie de la pince conductrice dans une direction hors plan ;
la formation d'un motif dans la première surface de la première partie de la pince conductrice de sorte que le motif comporte un plancher en dépression à partir duquel des ailettes s'étendent vers le haut ;
la formation d'orifices traversants dans le fond en dépression de la première partie de la pince conductrice ;
le couplage d'une deuxième face d'un circuit intégré (IC) à une première surface d'un premier substrat de support ;
le collage de la deuxième surface de la première partie de la pince conductrice à une première face de l'IC au moyen d'une couche de soudure formée entre elles ;
le couplage de la deuxième surface de la deuxième partie de la pince conductrice à une première surface d'un deuxième substrat de support qui est espacé de l'IC ;
le chauffage du dispositif électronique de sorte à refusionner la couche de soudure, les gaz libérés par la couche de soudure pendant la refusion s'échappant du dispositif électronique par les orifices traversants ce qui permet au dispositif électronique de refroidir ; et
la formation d'une couche d'encapsulation sur le dispositif électronique de sorte que la première surface de la pince conductrice soit laissée exposée.

5. Procédé selon la revendication 4, comprenant en outre, avant le couplage d'une deuxième face du circuit intégré (IC) à la première surface d'un premier substrat de support, le couplage de la deuxième surface du premier substrat de support à une première surface du substrat de base ; et comprenant en outre, après la formation de la couche d'encapsulation, le retrait du substrat de base du premier substrat de support.

6. Dispositif selon l'une quelconque des revendications 1 à 3, ou procédé selon la revendication 4 ou 5, dans lequel les orifices traversants sont coupés droit, étant de taille et de forme égales au niveau du fond en dépression du motif et au niveau de la deuxième surface de la pince conductrice.

7. Dispositif selon l'une quelconque des revendications 1 à 3 ou 6, ou procédé selon l'une quelconque des revendications 4 à 6, dans lequel les orifices traversants s'élargissent en taille depuis le fond en dépression du motif jusqu'à la deuxième surface de la pince conductrice de sorte que la taille des orifices traversants au niveau du fond en dépression soit inférieure à la taille des orifices traversants au niveau de la deuxième surface de la pince conductrice.

8. Dispositif selon l'une quelconque des revendications 1 à 3 ou 6, ou procédé selon l'une quelconque des revendications 4 à 6, dans lequel les orifices traversants se contractent en taille depuis le fond en dépression du motif jusqu'à la deuxième surface de la pince conductrice de sorte que la taille des orifices traversants au niveau du fond en dépression soit supérieure à la taille des orifices traversants au niveau de la deuxième surface de la pince conductrice.

9. Dispositif selon l'une quelconque des revendications 1 à 3, 6 à 8, ou procédé selon l'une quelconque des revendications 4 à 8, dans lequel les orifices traversants ont des sections transversales de forme circulaire.

10. Dispositif selon l'une quelconque des revendications 1 à 3, 6 à 9, ou procédé selon l'une quelconque des revendications 4 à 9, dans lequel les orifices traversants ont des sections transversales en forme de pilule.

11. Dispositif selon l'une quelconque des revendications 1 à 3, 6 à 9, ou procédé selon l'une quelconque des revendications 4 à 10, dans lequel le premier substrat de support est un plot de puce d'une grille de connexion.

12. Dispositif selon l'une quelconque des revendications 1 à 3, 6 à 9, ou procédé selon l'une quelconque des revendications 4 à 11, dans lequel le deuxième substrat de support est au moins un fil d'une grille de connexion.
